Europäisches Patentamt

(19) European Patent Office

Office européen des brevets

(11) Numéro de publication: **0 222 648**
**B1**

(12) **FASCICULE DE BREVET EUROPEEN**

(45) Date de publication du fascicule du brevet:
21.03.90

(21) Numéro de dépôt: 86402287.6

(22) Date de dépôt: 14.10.86

(51) Int. Cl.⁴: **H03K 19/094,** H03K 19/21,
H03K 23/66, H03K 23/40

(54) **Porte logique à coincidence, triplet de portes logiques, et circuit logique séquentiel mettant en oeuvre cette porte logique.**

(30) Priorité: 18.10.85 FR 8515506

(43) Date de publication de la demande:
20.05.87 Bulletin 87/21

(45) Mention de la délivrance du brevet:
21.03.90 Bulletin 90/12

(84) Etats contractants désignés:
DE GB IT NL

(56) Documents cités:
EP-A- 0 053 664
EP-A- 0 187 584
FR-A- 2 410 914

CONFERENCE PROCEEDINGS OF THE 11th
EUROPEAN MICROWAVE CONFERENCE, Amsterdam,
NL, 7-11 septembre 1981, pages 28-37; G. NUZILLAT:
"GaAS digital ICs for high-speed signal processing"
IEEE TRANSACTIONS ON ELECTRON DEVICES, vol.
ED-27, no. 6, juin 1980, pages 1102-1109, IEEE, New
York, US; G. NUZILLAT et al.: "Quasi-normally-off
MESFET logic for high-performance GaAs IC's"

(73) Titulaire: **THOMSON-CSF, 51, Esplanade du Général de
Gaulle, F-92800 Puteaux(FR)**

(72) Inventeur: **Pham, Ngu Tung, THOMSON-CSF
SCPI 19, avenue de Messine, F-75008 Paris(FR)**

(74) Mandataire: **Taboureau, James et al, THOMSON-CSF
SCPI, F-92045 Paris La Défense Cédex 67(FR)**

## Description

La présente invention concerne le domaine de la logique rapide, réalisée sous forme de circuits intégrés sur matériaux semiconducteurs du groupe III–V, tel que l'arseniure de gallium. Plus précisément, elle concerne une porte logique à coïncidence, un triplet constitué par trois portes logiques montées en série, et les circuits logiques séquentiels, de type diviseurs de fréquence programmables, réalisés au moyen de tels triplets de portes logiques.

Les moyens électroniques actuels utilisant des ondes hyperfréquences, c'est-à-dire les radars ou les télécommunications par exemple, mettent en œuvre des synthétiseurs de fréquences, dans lesquels les diviseurs de fréquences programmables jouent un rôle d'autant plus important que les performances de ces diviseurs doivent être adaptées au niveau de performances du matériel hyperfréquence, et fonctionner à des fréquences supérieures à 10 GHz.

Cet objectif est atteint à partir d'une porte-logique à coïnicidence, décrite dans la demande de brevet européen EP-A 0 187 584 du 10 décembre 1985 par la Demanderesse, cette porte logique étant modifiée, selon la présente invention, pour lui communiquer une plus grande vitesse de basculement, et la rendre "bouclable" dans un circuit comportant un triplet de trois portes logiques, dont la dernière est rebouclée sur la première. Ledit document appartient à l'état de la technique tel que défini à l'article 54 (3) CBE les états contractants désignés étant DE, GB et NL.

Le montage en séquence, ou en ligne, d'une pluralité de triplets de portes logiques, chacun ayant sa sortie réunie à l'entrée du triplet suivant et étant en outre rebouclé sur l'entrée – une porte OU – du premier triplet de la séquence, permet de réaliser des diviseurs de fréquences synchrones programmables, dont les rapports de division se suivent un par un: 3, 4, 5, 6, 7... etc.

Ainsi, un diviseur de fréquence programmable est composé d'une séquence de triplets de portes logiques à coïncidence, chaque porte logique étant constituée par deux inverseurs montés en parallèle, chaque inverseur comprenant un transistor dont la source est mise à la masse et dont le drain est alimenté par une tension à travers une résistance saturable, l'entrée de signal étant appliquée sur la grille du premier transistor du premier inverseur et l'entrée d'horloge étant appliquée sur la grille du second transistor du second inverseur, cette porte logique étant caractérisée en ce que:
– le premier inverseur comprend au moins une entrée de signal,
– le second inverseur est alimenté par un troisième transistor dont la source est reliée à la seconde résistance saturable et dont le drain, réuni à la grille, est relié à la première résistance saturable, au point commun entre celle-ci et le drain du premier transistor,
– la sortie de cette porte logique étant prise au point commun entre la deuxième résistance saturable et le troisième transistor.

L'invention sera mieux comprise par la description détaillée qui en est faite maintenant, celle-ci concernant trois cas d'application à des diviseurs par 3, par 4 et par 5, et s'appuyant sur les figures jointes en annexes, qui représentent:

– figure 1: schéma électrique d'une porte logique à coïncidence,
– figure 2: schéma électrique d'une porte logique à coïncidence, selon l'invention,
– figure 3: schéma électrique d'une porte logique à coïncidence, rebouclable, selon l'invention,
– figure 4: symbole de représentation simplifiée de la porte de la figure 2,
– figure 5: symbole de représentation simplifiée de la porte de la figure 3,
– figure 6: schéma de base, en bloc-diagramme, d'un diviseur de fréquence, utilisant les portes logiques selon l'invention,
– figure 7: schéma d'un diviseur de fréquence par 3, selon l'invention,
– figure 8: schéma d'un diviseur de fréquence par 5, selon l'invention,
– figure 9: schéma d'un triplet de portes constituant le premier étage d'une séquence de triplets, selon l'invention,
– figure 10: symbole de représentation simplifiée du triplet de la figure 9,
– figure 11: schéma d'un triplet de portes constituant un étage quelconque d'une séquence de triplets, selon l'invention,
– figure 12: symbole de représentation simplifiée du triplet de la figure 11,
– figure 13: schéma, en bloc diagramme, de généralisation d'un diviseur de fréquence utilisant les triplets de portes logiques selon l'invention,

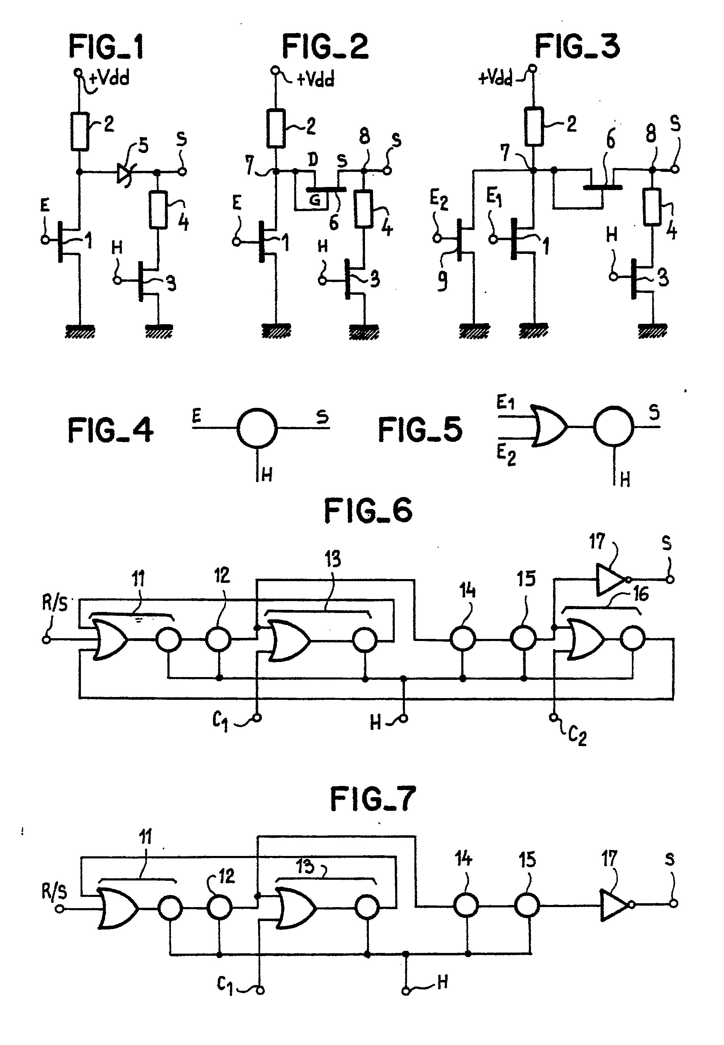

La figure 1 représente le schéma électrique d'une porte à coïncidence décrite dans la demande de brevet européen déjà citée. Elle met en œuvre des transistors à effet de champ de types normalement bloqué ou normalement passant, selon le type de circuit logiques dans lequel la porte à coïncidence de l'invention est mise en œuvre. Cependant, les caractéristiques dynamiques de la porte à coïncidence la font utiliser préférentiellement dans les circuits intégrés rapides, tels que ceux qui sont réalisés sur GaAs ou plus généralement sur matériaux du groupe III–V.

On appelle porte à coïncidence, ou porte à décision unanime, une porte logique comportant au moins deux entrées qui doivent être activées simultanément par des niveaux logiques pour que la sortie de la

EP 0 222 648 B1

porte à coïncidence change d'état. Les portes connues ont des commutations franches et rapides en fonction des signaux logiques appliqués aux entrées.

Cette porte à coïncidence ne change d'état que si les deux entrées sont activées par de mêmes niveaux logiques (coïncidence). Dans le cas contraire (anti-coïncidence), la porte garde son état antérieur.

Elle comporte deux transistors montés en parallèle, dont les grilles - s'il s'agit de transistors à effet de champ - constituent les entrées de la porte à coïncidence. Chaque transistor a sa source mise à la masse, et est alimenté par son drain à travers une résistance. La particularité de cette porte est que les tensions d'alimentation sont différentes pour les deux transistors. Le premier transistor 1 est alimenté à travers une première résistance saturable 2, de forte valeur, à partir d'une tension + $V_{DD}$. Le second transistor 3 est également alimenté à travers une seconde résistance 4 saturable, identique à la première, mais sa tension d'alimentation est prélevée, à travers une diode Schottky 5 montée dans le sens direct, au point commun entre la première résistance saturable 2 et le drain du premier transistor 1. La sortie S de cette porte à coïncidence est prélevée au point commun entre la diode Schottky 5 et la deuxième résistance saturable 4. En outre, la tension d'alimentation $V_{DD}$ est grande par rapport à la somme $V_H + V_D$, $V_H$ étant la tension au niveau haut en sortie de la porte à coïncidence, et $V_D$ étant la chute de tension à travers la diode 5 à l'état passant.

La grille du premier transistor 1 constitue la première entrée E de cette porte, et la grille du second transistor 3 en constitue la seconde entrée, appellée H parce qu'elle est attaquée par un signal d'horloge.

En outre, les deux résistances ou charges saturables 2 et 4 sont identiques, de valeur élevée et à faible tension de coude. Elles sont constituées par des transistors à effet de champ à canal creusé, sans métallisation de grille, qui se comportent comme des transistors quasi-normalement bloqués, ou par des transistors dont la grille est reliée à la source.

La porte de la figure 1 est donc constituée de deux inverseurs dits DCFL (Direct Coupled FET Logic, en anglais) -chaque inverseur étant un transistor et une charge- reliés par une diode Schottky 5. Or, une diode Schottky, sur arséniure de gallium, a une tension de seuil de l'ordre de $V_T = 1$ volt, -plus exactement 0;9 V pour l'or sur nGaAs- ce qui est une tension de seuil élevée, qui ralentit la vitesse de basculement de la porte. En effet, en logique rapide, la vitesse, c'est-à-dire l'inverse du temps de basculement d'un dispositif est inversement proportionnelle à sa tension de seuil, puisqu'un front de signal, arrivant sur ce dispositif, n'est jamais immédiat, au sens strict, mais a un certain temps de montée, même si ce temps s'exprime en nanosecondes ou picosecondes. Plus la tension de seuil est élevée, plus il faut de temps pour que le signal franchisse ce seuil, et fasse commuter, ou basculer le dispositif.

C'est donc un perfectionnement, dans le sens de la vitesse de commutation, que d'abaisser la tension de seuil du composant qui réunit les deux étages de cette porte à coïncidence.

La figure 2 représente le schéma électrique d'une porte à coïncidence selon l'invention. Elle comporte un premier étage constitué par un inverseur, transistor 1 et charge saturable 2, la source du transistor étant à la masse, ainsi qu'un second étage constitué par un second inverseur, transistor 3 et charge saturable 4. Mais le couplage entre le point 7 commun au premier transistor 1 et à la première charge 2, d'une part, et le point 8 d'alimentation du deuxième étage, d'autre part, se fait au moyen d'un transistor 6, dont la grille est reliée au drain et au point commun 7, et dont la source est reliée au point d'alimentation 8, qui constitue également le point de sortie S de cette porte à coïncidence.

L'intérêt de ce montage, par rapport à celui de la figure 1, est que la tension de seuil d'un transistor normalement bloqué, dont la grille est réunie au drain, est de l'ordre de 0,2 V, selon le matériau et la technologie employée, c'est-à-dire environ cinq fois plus faible qu'une diode Schottky, ce qui améliore la vitesse de commutation de la porte à coïncidence, qui peut travailler au delà de 40 GHz.

La porte de la figure 2, selon l'invention, comporte une entrée E sur le premier inverseur, et une entrée d'horloge H sur le second inverseur. Celle de la figure 3 comporte, dans son premier étage, au moins deux transistors 1 et 9, montés en parallèle, ce qui en fait une fonction OU, ou plus exactement, puisqu'il s'agit d'un inverseur, une fonction OU-NON. De façon plus générale, le premier étage de la porte à coïncidence selon l'invention comprend une pluralité de transistors montés en parallèle, dont les grilles constituent autant d'entrées $E_1$, $E_2$... à la fonction OU-NON, rendant possible le rebouclage de cette porte dans un montage séquentiel, c'est-à-dire le renvoi sur une entrée de la première porte du signal de sortie d'une porte d'ordre quelconque dans la séquence, ou encore rendant possible la commande d'une porte par un signal de commande autre que le signal d'horloge sur l'entrée H du second étage.

De la même façon que la porte à coïncidence de la figure 1, les portes des figures 2 et 3 ne commutent que si les deux étages ont le même état logique : elles fonctionnent alors en inverseur par rapport à l'état du premier étage. Dans le cas contraire, c'est-à-dire si les deux étages n'ont pas le même état logique, ces portes conservent leur état antérieur.

De façon à simplifier la structure des figures d'application des portes à coïncidence selon l'invention, on conviendra de représenter la porte n'ayant qu'une seule entrée E dans son premier étage (figure 2) par un symbole, un cercle, muni de trois connexions externes d'entrée E, d'horloge H et de sortie S, tel que représenté en figure 4. Pour la même raison, la porte ayant une pluralité d'entrées $E_1$, $E_2$... dans son premier étage (figure 3) sera représentée par un cercle, précédé d'une fonction OU, ainsi qu'en fi-

3

gure 5. Bien entendu, ces deux portes à coïncidence sont alimentées, par une tension + V<sub>DD</sub> par rapport à une masse, mais la représentation de la tension d'alimentation n'apporte rien à la compréhension de l'invention, et surcharge les figures.

La figure 6 représente le schéma de base, utilisant les symboles des figures 4 et 5, d'un circuit logique séquentiel qui est un diviseur de fréquence programmable. Il est constitué de deux boucles.

La première boucle comprend une séquence de trois portes à coïncidence 11, 12, 13 que l'on appellera un triplet. La première porte 11 du triplet est une porte munie d'une fonction OU (selon la figure 3) à 3 entrées : deux entrées de rebouclage et une entrée RS (set-reset) de remise à zéro. Cette première porte 11 ne comprend pas d'entrée de signal à proprement parler. Le signal d'entrée est constitué par le signal d'horloge H, qui est adressé à l apremière porte par l'intermédiaire des entrées de rebouclage. La sortie de la porte 11 constitue l'entrée de la porte 12, qui est une porte à une seule entrée (selon la figure 2). La sortie de la porte 12 constitue l'une des entrées de la porte 13, munie d'une fonction OU, dont la deuxième entrée $C_1$ est commandée par un signal logique de programmation qui est soit un O logique, soit un 1 logique. La sortie de la porte 13 est rebouclée sur l'une des entrées du OU de la première porte 11. La sortie de ce premier triplet est prise sur la sortie de la deuxième porte 12.

La deuxième boucle de ce diviseur de fréquence comprend les portes 11 est 12 du premier triplet plus un second triplet de portes à coïncidence 14, 15, 16 selon l'invention.

La première porte 14, du type à une seule entrée, a son entrée réunie à la sortie du précédent triplet. La sortie de la porte 14 constitue l'entrée de la porte 15, du type à une seule entrée. La sortie de la porte 15 constitue l'une des entrées de la porte 16, munie d'une fonction OU, dont la deuxième entrée $C_2$ est commandée par un signal logique de programmation, O logique, ou 1 logique. La sortie de la porte 16 est rebouclée sur une entrée du OU de la première porte 11 de la première boucle.

La sortie de la deuxième porte 15 de la deuxième boucle constitue la sortie S du diviseur de fréquence, qui est pratiquement toujours prélevée après un inverseur 17. Les entrées d'horloge H de toutes les portes du diviseur de fréquence sont réunies et commandées de façon synchrone : ce diviseur de fréquence divise sa propre fréquence d'horloge.

Les modes de fonctionnement de ce circuit de base à deux boucles sont fonction des valeurs logiques des signaux de commande en $C_1$ et $C_2$ :

| $C_1$ | $C_2$ | fonction |
|---|---|---|
| 0 | 0 | diviseur par 4 |
| 0 | 1 | diviseur par 3 |
| 1 | 0 | diviseur par 5 |

Considérons d'abord le cas où $C_1 = C_2 = 0$ logique ; le circuit est un diviseur de fréquence constitué d'une boucle de portes 11-12-13-11 et d'une boucle de portes 11-12-14-15-16-11 : ces deux boucles sont fermées sur elles-mêmes, simultanément.

Connaissant les états d'une porte à coïncidence élémentaire, telle que celle de la figure 2 ou de la figure 3, qui ne commute que si les mêmes niveaux logiques sont appliqués sur les entrées de ses deux étages, le circuit de fréquence selon l'invention prend les états du tableau ci-dessous :

| Séquence | Entrées de | | | | | Sorties de | | | Sortie |
|---|---|---|---|---|---|---|---|---|---|
| | H | R/S | 13 et 16 | 11 | 12 | 13 et 14 | 15 | 16 | S |
| 1 | 1 | 1 | 0 | 0 | 1 | 0 | 1 | 0 | 1 |
| 1 | 0 | 1 | 0 | 0 | 1 | 0 | 1 | 0 | 1 |
| 2 | 1 | 0 | 0 | 0 | 1 | 0 | 1 | 0 | 1 |
| 2 | 0 | 0 | 0 | 1 | 1 | 0 | 1 | 0 | 1 |
| 3 | 1 | 0 | 0 | 1 | 0 | 0 | 1 | 0 | 1 |
| 3 | 0 | 0 | 1 | 1 | 0 | 1 | 1 | 0 | 1 |
| 4 | 1 | 0 | 1 | 0 | 0 | 1 | 0 | 0 | 0 |
| 4 | 0 | 0 | 1 | 0 | 1 | 1 | 0 | 1 | 0 |
| 5 | 1 | 0 | 1 | 0 | 1 | 0 | 0 | 1 | 0 |
| 5 | 0 | 0 | 1 | 0 | 1 | 0 | 1 | 1 | 1 |
| 6 | 1 | 0 | 0 | 0 | 1 | 0 | 1 | 0 | 1 |
| 6 | 0 | 0 | 0 | 1 | 1 | 0 | 1 | 0 | 1 |

Chaque séquence correspond à une période d'horloge, c'est-à-dire une demi-période H = 1 logique et une demi-période H = 0 logique.

La séquence 1 correspond à une remise à 1 (reset). Une fois que l'entrée R/S est remise à zéro, le circuit fonctionne avec un cycle de 4 d'horloge H, c'est-à-dire un diviseur dynamique par 4.

La figure 7 représente le schéma d'un diviseur de fréquence qui a la même configuration que celui de la figure 6, mais dans le cas où les signaux de commande de programme sont $C_1 = 0$ et $C_2 = 1$ logiques. Les mêmes symboles et indices de repère que sur la précédente figure sont conservés. La condition $C_2 = 1$ logique impose que la sortie de la porte 16 est au zéro logique : la porte 16 est inactive dans ce cas, c'est pourquoi elle n'est pas représentée sur la figure 7. En outre, puisque la sortie de la porte 16 est au niveau bas logique, on ne peut plus parler de rebouclage sur une entrée du OU de la première porte 11 du premier triplet. Il n'y a plus dans ce cas qu'une seule boucle 11-12-13-11, et les portes 14 et 15 du second triplet ne servent qu'à transmettre les états logiques à la sortie S du diviseur de fréquence, prélevée sur la sortie de la deuxième porte 15 du second triplet. Ce circuit, composé d'un seul triplet rebouclé sur lui-même, est un diviseur de fréquence par 3.

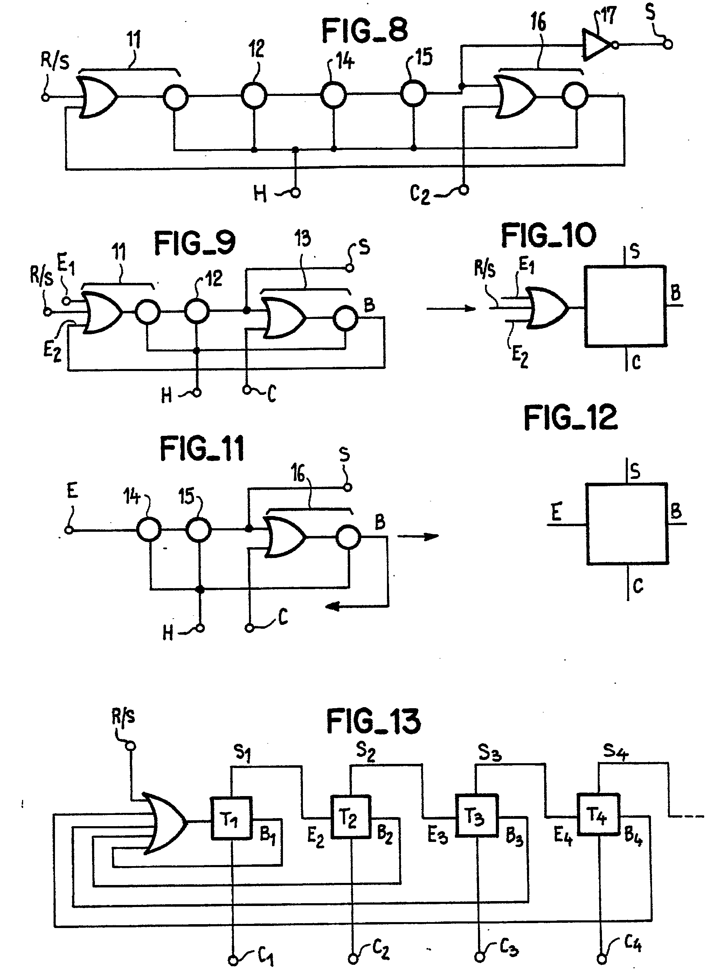

Le circuit de la figure 8 correspond toujours à la même configuration que celui de la figure 6, mais dans le cas où les signaux de commande de programmation sont $C_1 = 1$ et $C_2 = 0$. Le même raisonnement que celui qui précède amène à considérer que la porte 13 du premier triplet a une sortie au niveau bas logique : le premier triplet n'est pas rebouclé sur lui-même, et la porte 13, rendue inactive, est supprimée sur la figure 8. Il n'y a plus qu'une seule boucle, constituée par les portes à coïncidence 11-12-14-15-16-11. Ce circuit est un circuit diviseur de fréquence dynamique par 5.

Les figures 6, 7 et 8 sont trois cas d'une même configuration -celle de la figure 6- comprenant deux triplets de portes à coïncidence, et deux boucles, toutes deux refermées sur le OU de la première porte du premier triplet.

De façon plus générale, des diviseurs de fréquence d'ordre 2n + 1 sont obtenus avec un circuit d'une boucle comportant 2n + 1 portes à coïncidence, et des diviseurs de fréquence d'ordre 2n sont obtenus avec un circuit comportant deux boucles de 2n - 1 et 2n + 1 portes à coïncidence. Dans tous les cas, et quel que soit le nombre de triplets de portes qui sont connectés en séquence, le niveau logique des signaux de commande C fait qu'un certain nombre de rebouclages -les sorties des portes 13 ou 16- sont interrompus, parce que ces sorties sont au niveau 0 logique, et il ne reste qu'une boucle active pour un diviseur d'ordre impair, et deux boucles actives pour un diviseur d'ordre pair.

Cette généralisation du circuit diviseur de fréquence programmable est représentée par la figure 13, que les figures 9 à 12 permettent de comprendre plus facilement.

En effet, la figure 9 représente un triplet de portes à coïncidence selon la convention établie par les figures 4 et 5. Ce triplet comporte deux portes, 11 et 13, munies d'une fonction OU : c'est le premier triplet d'une séquence, et sa fonction OU comporte autant d'entrées $E_1$, $E_2$... qu'il y a de triplets dans la séquence du diviseur, plus une entrée R/S de remise à 1. En vue de simplifier la figure 13, on conviendra de symboliser ce triplet selon la figure 10 par un carré précédé d'un OU. Ce carré a une entrée de signaux à travers le OU, une entrée de commande de programmation C, une sortie S et une sortie de bouclage B.

De façon analogue, la figure 11 représente un triplet de la séquence autre que le premier triplet : seule sa troisième porte 16 est munie d'une fonction OU, et on conviendra de le symboliser selon la figure 12, par un carré muni de deux entrées E et C et de deux sorties S et B.

Dans un circuit séquentiel tel que celui de la figure 13, qui comporte 4 triplets, bien que ce nombre ne constitue pas une limite à la portée de l'invention, la sélection du rapport de division du diviseur de fréquence s'obtient en mettant une ou deux commandes C de programmation voisines à zéro, et les autres à 1. Si une seule commande C de programmation est mis à 0 logique, le rapport de division est impair. Si deux commandes voisines sont mise à 0 logique, le rapport de division est pair.

Le tableau ci-dessous donne un exemple des possibilités de programmation d'un diviseur réalisé avec quatre triplets $T_1$ $T_2$ $T_3$ $T_4$, dont les entrées de programmation sont $C_1$ $C_2$ $C_3$ $C_4$.

| $C_1$ | $C_2$ | $C_3$ | $C_4$ | Fonction Division par : |
|---|---|---|---|---|
| 0 | 1 | 1 | 1 | 3 |
| 0 | 0 | 1 | 1 | 4 |
| 1 | 0 | 1 | 1 | 5 |
| 1 | 0 | 0 | 1 | 6 |
| 1 | 1 | 0 | 1 | 7 |
| 1 | 1 | 0 | 0 | 8 |
| 1 | 1 | 1 | 0 | 9 |

On peut réaliser selon ce circuit séquentiel un diviseur de fréquence programmable jusqu'à un nombre relativement grand de rapports successifs de division, car les portes à coïncidence, fonctionnant à très haute fréquence, sont constamment rafraichies. Par conséquent, les diviseurs de fréquence selon l'invention peuvent être très stables malgré la longueur des séquences.

Ils sont utilisés dans les systèmes hyperfréquences fonctionnant entre 10 et 100 GHz, dans lesquels on divise la fréquence reçue, en télédétection par exemple, avant de traiter le signal et les informations qu'il contient.

## Revendications

1. Porte logique à coïncidence, constituée par deux inverseurs montés en parallèle, chaque inverseur étant constitué par un transistor (1, 3) dont la source est mise à la masse et dont le drain est alimenté par une tension à travers une résistance saturables (2, 4), l'entrée de signal (E) étant appliquée sur la grille du premier transistor (1) du premier inverseur (1+2) et l'entrée d'horloge (H) étant appliquée sur la grille du second transistor (3) du second inverseur (3+4), la sortie (S) de cette porte logique étant prise au point d'alimentation (8) du second inverseur (3+4), qui est alimenté par un troisième transistor (6) dont la source est reliée (en 8) à la seconde résistance saturable (4) et dont le drain, réuni à la grille, est relié à la première résistance saturable (2), au point commun (7) entre celle-ci (2) et le drain du premier transistor (1).

2. Porte logique selon la revendication 1, caractérisée en ce que le premier inverseur (1+2) comprend au moins une entrée supplémentaire ($E_2$), sur la source d'un quatrième transistor (9) monté en parallèle avec le premier transistor (1) et formant une fonction OU.

3. Triplet de portes logiques comprenant une séquence de trois portes logiques (14, 15, 16) selon la revendication 1, montée en série, la sortie d'une porte (14) constituant l'entrée de la porte suivante (15) dans la séquence, les commandes d' horloge (H) de ces portes (14, 15, 16) étant synchrones, ce triplet étant caractérisé en ce que:
   – l'entrée du triplet est constituée par l'entrée de la première porte (14) de la séquence,
   – la sortie du triplet est prise sur la sortie de la deuxième porte (15),
   – la troisième porte (16) comprend une entrée supplémentaire ($C_2$) de commande de programmation (0 ou 1 logique) et une sortie de rebouclage.

4. Triplet de portes logiques (11, 12, 13) selon la revendication 3, caractérisé en ce que la première porte (11) de la séquence comprend une entrée supplémentaire (R/S) de remise à 1 logique, et au moins une entrée supplémentaire de rebouclage.

5. Circuit logique séquentiel comprenant au moins deux triplets de portes logiques selon la revendication 3, montés en série, caractérisé en ce que:
   – la première porte (11) du premier triplet (11, 12, 13) comprend une entrée supplémentaire (R/S) de remise à 1 logique et autant d'entrées supplémentaires de rebouclage qu'il y a de triplets dans la séquence,
   – la sortie d'un triplet (11, 12, 13) est reliée à l'entrée du triplet suivant (14, 15, 16) dans la séquence,
   – toutes les sorties de rebouclage des triplets de la séquence sont reliées, chacune, à une entrée de rebouclage de la première porte (11) du premier triplet (11, 12, 13).

6. Circuit logique séquentiel selon la revendication 5, caractérisé en ce qu'il constitue un circuit diviseur de fréquence programmable, un rapport de division impaire étant obtenu en mettant au niveau 0 logique l'entrée de programmation ($C_1$) de l'un des triplets de la séquence, et au niveau 1 logique les entrées de programmation ($C_2$, $C_3$, $C_4$...) des autres triplets de la séquence.

7. Circuit logique séquentiel selon la revendication 5, caractérisé en ce qu'il constitue un circuit diviseur de fréquence programmable, un rapport de division pair étant obtenu en mettant au niveau 0 logique deux entrées de programmation ($C_1$, $C_2$) de deux triplets voisins dans la séquence, et au niveau 1 logique les entrées de programmation ($C_3$, $C_4$...) des autres triplets de la séquence.

8. Circuit logique séquentiel selon la revendication 6, caractérisé en ce qu'il constitue un circuit diviseur de fréquence de rapport de division $2n+1$ au moyen d'une seule boucle de $2n+1$ portes à coïncidence (11, 12, 14, 15, 16), les triplets dont les entrées de programmation ($C_2$, $C_3$, $C_4$...) sont au niveau 1 logique n'étant pas rebouclés.

9. Circuit logique séquentiel selon la revendication 7, caractérisé en ce qu'il constitue un circuit diviseur de fréquence de rapport de division $2n$ au moyen de deux boucles de $2n-1$ portes (11, 12, 13) et $2n+1$ portes (11, 12, 14, 15, 16) portes.

10. Circuit logique séquentiel selon l'une quelconque des revendications 5 à 9, caractérisé en ce qu'il est réalisé sous forme de circuit intégré sur GaAs.

**Claims**

1. A logic coincidence gate, constituted by two inverters connected in parallel, each inverter being constituted by a transistor (1, 3), whose source is connected to ground and whose drain is supplied via a saturable resistor (2, 4) with a voltage, the input signal (E) being applied to the grid of the first transistor (1) of the first inverter (1+2) and the clock input (H) being applied to the grid of the second transistor (3) of the second inverter (3+4), the output (5) of said logic gate being constituted by feed point (8) of the second inverter (3+4), which is fed by a third transistor (6), whose source is connected (at 8) to the second saturable resistor (4) and whose drain is linked to the grid and is connected to the first saturable resistor (2) at the common connection point (7) between the latter (2) and the drain of the first transistor (1).

2. A logic gate according to claim 1, characterized in that the first inverter (1+2) comprises at least one additional input ($E_2$) at the source of a fourth transistor (9), which is connected in parallel to the first transistor (1) and forms an OR-function.

3. A triplet of logic gate, comprising a sequence of three logic gates (14, 15, 16) according to claim 1, connected in series, the output of one gate (14) constituting the input of the following gate (15) in the sequence and the clock control signals (H) of said gates (14, 15, 16) being synchronized, said triplet being characterized in that:
   – the input of the triplet is constituted by the input of the first gate (14) in the sequence;
   – the output of the triplet is constituted by the output of the second gate (15); and
   – the third gate (16) comprises an additional programming control input ($C_3$) (logic 0 or 1) and a feedback output.

4. A triplet of logic gates (11, 12, 13) according to claim 3, characterized in that the first gate (11) in the sequence comprises an additional reset-to-one logic input (R/S) and at least one additional feedback input.

5. A sequential logic circuit, comprising at least two series-connected triplets of logic gates according to claim 3, characterized in that:
   – the first gate (11) of the first triplet (11, 12, 13) comprises an additional reset-to-one input (R/S) and as many additional feedback inputs as there are triplets in the sequence;
   – the output of one triplet (11, 12, 13) is connected to the input of the following triplet (14, 15, 16) in the sequence; and
   – all the feedback outputs of the triplets in the sequence are connected to a feedback input of the first gate (11) of the first triplet (11, 12, 13).

6. A sequential logic circuit according to claim 5, characterized in that it constitutes a programmable frequency divider circuit, with an odd division ratio being obtained by putting the programming input ($C_1$) of one of the triplets in the sequence to logic level zero and the programming inputs of the other triplets ($C_2$, $C_3$, $C_4$ ...) in the sequence to logic level one.

7. A sequential logic circuit according to claim 5, characterized in that it constitutes a programmable frequency divider circuit, with an even division ratio being obtained by putting the two programming inputs ($C_1$, $C_2$) of two neighbouring triplets in the sequence to zero level and the programming inputs ($C_3$, $C_4$ ...) of the other triplets in the sequence to logic level one.

8. A sequential logic circuit according to claim 6, characterized in that it constitutes a frequency divider circuit implementing a division ratio of 2n+1, which is made up of a single loop including 2n+1 coincidence gates (11, 12, 14, 15, 16), with those triplets left out of the loop, whose inputs provided for programming ($C_2$, $C_3$, $C_4$ ...) are at logic level one.

9. A sequential logic circuit according to claim 7, characterized in that it constitutes a frequency divider circuit implementing a division ratio of 2n, which is made up of two loops including 2n-1 gates (11, 12, 13) and 2n+1 gates (11, 12, 14, 15, 16) respectively.

10. A sequential logic circuit according to anyone of claims 5 to 9, characterized in that it is embodied by way of an integrated circuit on a GaAs material.

## Patentansprüche

1. Logisches Koinzidenztor, bestehend aus zwei parallelgeschalteten Invertern, die je aus einem Transistor (1, 3) bestehen, dessen Source an Masse und dessen Drain über einen sättigbaren Widerstand (2, 4) mit einer Spannung gespeist wird, wobei der Signaleingang (E) an das Gitter des ersten Transistors (1) des ersten Inverters (1+2) und der Takteingang (H) an das Gitter des zweiten Transistors (3) des zweiten Inverters (3+4) angeschaltet ist und der Ausgang (5) dieses logischen Tors am Speisepunkt (8) des zweiten Inverters (3+4) liegt, der von einem dritten Transistor (6) gespeist wird, dessen Source (bei 8) an den zweiten sättigbaren Widerstand (4) und dessen Drain, der an das Gitter angeschlossen ist, mit dem ersten sättigbaren Widerstand (2) am gemeinsamen Anschlußpunkt (7) zwischen letzterem (2) und dem Drain des ersten Transistors (1), verbunden ist.

2. Logisches Tor nach Anspruch 1, dadurch gekennzeichnet, daß der erste Inverter (1+2) mindestens einen zusätzlichen Eingang ($E_2$) an der Source eines vierten Transistors (g) aufweist, der dem ersten Transistor (1) parallelgeschaltet ist und eine ODER-Funktion bildet.

3. Logisches Tortriplett mit einer Reihenschaltungsfolge von drei logischen Toren (14, 15, 16) gemäß Anspruch 1, wobei in der Folge der Ausgang eines Tors (14) den Eingang des folgenden Tors (15) bildet und die Taktsteuerungen (H) dieser Tore (14, 15, 16) synchronisiert sind, dadurch gekennzeichnet, daß
   – der Eingang des Tripletts durch den Eingang des ersten Tores (14) der Folge gebildet wird,
   – der Ausgang des Tripletts vom Ausgang des zweiten Tores (15) gebildet wird, und
   – das dritte Tor (16) einen zusätzlichen Programm-Befehlseingang ($C_2$) (logisch 0 oder 1) und einen Rückschleifungsausgang besitzt.

4. Logisches Tortriplett (11, 12, 13) nach Anspruch 3, dadurch gekennzeichnet, daß das erste Tor (11) der Folge einen zusätzlichen Eingang (R/S) zum Rückstellen auf logisch 1 sowie mindestens einen zusätzlichen Rückschleifungseingang besitzt.

5. Logische Folgeschaltung mit mindestens zwei logischen Tortripletts nach Anspruch 3, die in der Reihe geschaltet sind, dadurch gekennzeichnet, daß
   – das erste Tor (11) des ersten Tripletts (11, 12, 13) einen zusätzlichen Eingang (R/S) zum Rückstellen auf logisch 1 und ebensoviele zusätzliche Rückschleifungseingänge aufweist, wie es Tripletts in der Folge gibt,
   – der Ausgang eines Tripletts (11, 12, 13) mit dem Eingang des folgenden Tripletts (14, 15, 16) in der Folge verbunden ist, und
   – alle Rückschleifungsausgänge der Tripletts der Folge jeweils an einen Rückschleifungseingang des ersten Tors (11) des ersten Tripletts (11, 12, 13) angeschlossen sind.

6. Logische Folgeschaltung nach Anspruch 5, dadurch gekennzeichnet, daß sie eine programmierbare Frequenzteilerschaltung bildet, wobei ein ungerades Teilungsverhältnis durch Anlegen des logischen Pegels 0 an den Programmiereingang ($C_1$) eines der Tripletts der Folge und des logischen Pegels 1 an die Programmiereingänge ($C_2$, $C_3$, $C_4$) der anderen Tripletts der Folge erzielt wird.

7. Logische Folgeschaltung nach Anspruch 5, dadurch gekennzeichnet, daß sie eine programmierbare Frequenzteilerschaltung bildet, wobei ein gerades Teilungsverhältnis durch Anlegen des logischen Pegels 0 an die Programmiereingänge ($C_1$, $C_2$) von zwei benachbarten Tripletts der Folge und des logischen Pegels 1 an die Programmiereingänge ($C_3$, $C_4$ ...) der anderen Tripletts der Folge erzielt wird.

8. Logische Folgeschaltung nach Anspruch 6, dadurch gekennzeichnet, daß sie eine Frequenzteilerschaltung mit Teilungsverhältnis 2n+1 mit Hilfe einer einzigen Schleife von 2n+1 Koinzidenztoren (11, 12, 14, 15, 16) bildet, wobei die Tripletts, deren Programmiereingänge ($C_2$, $C_3$, $C_4$ ...) auf Logikpegel 1 liegen, nicht zurückgeschleift sind.

9. Logische Folgeschaltung nach Anspruch 7, dadurch gekennzeichnet, daß sie mit Hilfe zweier Schleifen von 2n-1 Toren (11, 12, 13) und von 2n+1 Toren (11, 12, 14, 14, 16) eine Frequenzteilerschaltung mit Teilungsverhältnis 2n bildet.

10. Logische Folgeschaltung nach einem beliebigen der Ansprüche 5 bis 9, dadurch gekennzeichnet, daß sie in Form eines integrierten Schaltkreises auf GaAs-Basis ausgebildet ist.

# FIG_1

+Vdd

2

5

S

E

1

4

H

3

# FIG_2

+Vdd

2

7    D    S    8    S

G

E

1    6

H

3

4

# FIG_3

+Vdd

2

7    6    8    S

E₂    E₁

1

9

H

3

4

# FIG_4

E ⎯⎯⎯ ◯ ⎯⎯⎯ S

H

# FIG_5

E₁

E₂

◯ ⎯⎯⎯ S

H

# FIG_6

R/S    11    12    13    14    15    17    S

16

C₁    H    C₂

# FIG_7

R/S    11    12    13    14    15    17    S

C₁    H

EP 0 222 648 B1

## FIG_8

## FIG_9

## FIG_10

## FIG_11

## FIG_12

## FIG_13